Europäisches Patentamt

(19) European Patent Office  (11) Numéro de publication: **0 270 625**

Office européen des brevets  **B1**

(12)  **FASCICULE DE BREVET EUROPEEN**

(45) Date de publication du fascicule du brevet: **25.04.90**  (51) Int. Cl.⁵: **G 01 P 15/08, H 01 L 27/20, H 01 L 29/60, H 01 L 29/84**

(21) Numéro de dépôt: **87903879.2**

(22) Date de dépôt: **10.06.87**

(86) Numéro de dépôt international: **PCT/FR87/00206**

(87) Numéro de publication internationale: **WO 87/07729 17.12.87 Gazette 87/28**

(54) **CAPTEUR DE GRANDEURS MECANIQUES INTEGRE SUR SILICIUM ET PROCEDE DE FABRICATION.**

(30) Priorité: **10.06.86 FR 8608525**

(43) Date de publication de la demande:
**15.06.88 Bulletin 88/24**

(45) Mention de la délivrance du brevet:
**25.04.90 Bulletin 90/17**

(84) Etats contractants désignés:
**AT BE CH DE GB IT LI NL SE**

(56) Documents cités:
**DE-A-3 013 770**
**DE-A-3 201 198**
**FR-A-2 578 323**
**US-A-4 378 510**

(73) Titulaire: **METRAVIB R.D.S. Société Anonyme**
**64, Chemin des Mouilles B.P. 182**
**F-69132 Ecully Cédex (FR)**

(72) Inventeur: **ANDRE, Pierre**
**39, rue Albéric Pont**
**F-69005 Lyon (FR)**
Inventeur: **BAILLIEU, François**
**36, avenue du Coin du Bois**
**F-78120 Rambouillet (FR)**
Inventeur: **BROSSELARD, Jean-Pierre**
**2, passage Championnet**
**F-75018 Paris (FR)**
Inventeur: **PERMUY, Alfred**
**Groupe "Les Caillols" B8 Chemin des Campanulles**
**F-13012 Marseille (FR)**
Inventeur: **PIROT, François-Xavier**
**26, rue des Boulangers**
**F-75005 Paris (FR)**
Inventeur: **SPIRKOVITCH, Serge**
**68, rue des Cévennes**
**F-75015 Paris (FR)**

(74) Mandataire: **Ropital-Bonvarlet, Claude**
**Cabinet BEAU DE LOMENIE 99, Grande rue de la Guillotière**
**F-69007 Lyon (FR)**

Courier Press, Leamington Spa, England.

## Description

Domaine Technique:

La présente invention a pour objet un capteur de grandeurs mécaniques intégré sur silicium, comprenant un substrat de silicium monocristallin présentant un premier type de dopage (A), un condensateur variable comprenant une première armature mobile constituée par l'extrémité libre d'une lame conductrice déformable en flexion montée de manière à présenter une partie en porte-à-faux, et une seconde armature fixe constituée par une zone conductrice réalisée au niveau de la surface libre fixe du capteur en regard de ladite première armature et séparée de celle-ci par un espace libre dont l'épaisseur est de l'ordre de quelques µm, et des moyens de détection d'un signal élictrique significatif représentatif des variations de position de ladite lame flexible.

Art Anterieur:

On connait déjà des capteurs de grandeurs mécaniques intégrés de ce type, destinés à la mesure de forces, accélérations, ou pressions et comprenant une petite poutre en porte-à-faux formée dans une pastille de silicium, afin de constituer, au sein même d'un circuit intégré, un élément sensible à des accélérations perpendiculaires aux surfaces de la pastille de silicium, pour povoquer des variations de la capacité d'un condensateur variable et permettre, par la détection des variations de capacité, la délivrance d'un signal électrique représentatif de la grandeur mesurée.

La réalisation d'un capteur intégré sur du silicium permet d'accroître la compatibilité avec les circuits électroniques de traitement numérique associés aux capteurs. Toutefois, les capteurs intégrés de grandeurs mécaniques à effet capacitif connus présentent des inconvénients dans la mesure où les moyens de détection des variations de la capacité du condensateur variable dont l'une des armatures est constituée par une lame flexible font appel à des structures du type MOS (métal-oxyde-semi-conducteur) qui ne permettent pas des mesures suffisamment fiables ou précises du fait des capacités parasites, des dérives dans le temps, du bruit relativement important et de l'impossibilité d'imposer une fréquence de coupure basse.

Par ailleurs, la fabrication de capteurs incorporant une lame en porte-à-faux située à une très faible distance du substrat, de l'ordre de quelques microns, s'avère délicate et il est souvent difficile d'empêcher ou de faire cesser un collage de la lame sur le substrat par suite de l'attraction entre deux zones de dopage différent lorsque la distance entre ces deux zones est très faible.

Expose de l'Invention:

La présente invention vise à remédier aux inconvénients précités et à permettre la réalistion d'un capteur de grandeurs mécaniques intégré sur silicium, dont la fabrication et les dimensions sont compatibles avec la technologie des circuits électroniques intégrés, qui peut être fabriqué de façon précise et sûre et dont la sensibilité et la fiabilité sont améliorées de manière à permettre des mesures précises même dans des conditions d'environnement difficile.

Ces buts sont atteints grâce à un capteur du type défini en tête de la description, caractérisé en ce que le substrat est recouvert sur au moins une partie de sa surface par une couche dopée présentant un second type de dopage (B), en ce que ladite lame déformable conductrice présente une partie d'ancrage conductrice rapportée sur une zone localisée de ladite couche dopée, en ce que le capteur comprend dans ladite couche dopée une première zone dopée à forte concentration d'impuretés du premier type ($A^+$) située dans ladite zone localisée d'ancrage de la lame flexible pour constituer la grille G d'un transistor à effet de champ à jonction JFET, des seconde et troisième zones dopées à forte concentration d'impuretés du second type ($B^+$) situées de part et d'autre de ladite première zone dopée pour constituer des zones de drain D et de source S du transistor JFET, la couche dopée définissant une zone à faible concentration d'impuretés dudit second type (B) située sous ladite première zone dopée entre lesdites seconde et troisième zones pour constituer le canal dudit transistor JFET dont la grille G est reliée directement par la lame flexible à l'armature mobile du condensateur variable.

La lame flexible peut avantageusement être constituée en polysilicium dopé pour le rendre conducteur.

Selon un premier mode de réalisation, ladite zone conductrice sous-jacente est constituée par une quatrième zone dopée à forte concentration d'impuretés du second type ($B^+$) réalisée directement dans le substrat.

Selon un autre mode de réalisation, ladite zone conductrice sous-jacente est constituée par une quatrième zone dopée à forte concentration d'impuretés du premier type ($A^+$) réalisée dans la couche dopée.

Le capteur peut présenter un sensibilité encore améliorée s'il comprend un transistor JFET réalisé en anneau avec une seconde zone de drain ou de source qui constitue une zone centrale, une première zone de grille qui entoure de façon non contiguë la zone centrale de drain ou de source, une troisième zone de source ou de drain qui entoure elle-même de façon non contiguë la première zone de grille, une zone conductrice périphérique qui est disposée de façon non contiguë à l'extérieur de la troisième zone de source ou de drain, une zone de canal située dans les intervalles entre les seconde et première zones, entre les première et troisième zones et sous celles-ci, et si la lame flexible présente une partie en porte-à-faux qui s'étend radialement vers l'extérieur, de la première zone vers la zone conductrice.

Dans ce cas, le capteur peut comprendre plusieurs lames flexibles s'étendant radialement vers l'extérieur entre une zone d'ancrage constituée par une couronne superposée à la première zone et des zones conductrices en nombre égal au nombre de lames flexibles et non contiguës entre elles, au-dessus desquelles s'étendent respectivement les parties terminales d'extrémité libre des lames flexibles.

Selon un mode particulier de réalisation, permettant de rétablir facilement et sans démontage du boîtier l'intégrité du capteur après un choc ayant provoqué un collage sur le substrat de la lame flexible en porte-à-faux, la lame flexible présente une partie en porte-à-faux constituée par un ensemble de marches d'escalier présentant chacune une longueur inférieure à une longueur critique de collage, chaque marche d'escalier coopére avec une zone dopée à forte concentration d'impuretés polarisable individuellement située sous ladite marche, et des moyens sont prévus pour appliquer successivement de proche en proche sur chaque zone dopée polarisable individuellement, à partir de l'extrémité libre de la lame flexible, une polarisation pour permettre le décollage des marches successives en cas de collage accidentel de la partie libre de la lame flexible sur le substrat.

L'invention s'applique également à des capteurs à lame flexible sans porte-à-faux qui sont constitués par l'association symétrique de deux capteurs selon l'invention dans lesquels les parties d'extrémité libre des lames flexibles sont réunies entre elles pour former une lame flexible unique ancrée à ses deux extrémités.

L'invention a encore pour objet un procédé de fabrication d'un capteur de grandeurs mécaniques intégré tel que défini plus haut, caractérisé en ce que l'on réalise dans un premier temps la couche dopée, les première, seconde et troisième zones dopées à forte concentration d'impuretés et la zone conductrice, en ce que l'on forme ensuite une couche de silice qui suit la réalisation éventuelle d'une couche de passivation, en ce que l'on dégage par photogravure la silice dans la zone d'ancrage de la lame flexible, en ce que l'on dispose une matière conductrice dans la zone d'ancrage et sur une partie de la couche de silice pour constituer la lame flexible, en ce que l'on réalise le cas échéant une surcharge à l'extrémité libre de la lame flexible, en ce que l'on procède à l'ouverture de contacts à travers la couche de silice et éventuellement de passivation, puis au dépôt d'aluminium et à la photogravure de l'aluminium pour réaliser des chemins conducteurs de connexion, en ce que l'on procède à la dècoupe de plaquettes, à la mise en boîter et à la soudure de plots et en ce que dans une étape finale on enlève la silice y compris sous la matière conductrice de la partie en porte-à-faux de la lame flexible, par de l'acide fluorhydrique gazeux anhydre à une température comprise entre environ 50°C et 200°C et, de préférence, comprise entre 50°C et 100°C de manière à empêcher la formation de gouttelettes de liquide sur la plaquette.

Breve Description Des Dessins:

D'autres caractéristiques et avantages de l'invention ressortiront de la description suivante de modes particuliers de réalisation, donnés à titre d'exemples, en référence aux dessins annexés, sur lesquels:

la fig. 1 est une vue schématique en coupe montrant un premier mode de réalisation d'un capteur selon l'invention,

la fig. 2 est une vue en plan montrant un mode particulier de réalisation d'un capteur avec une structure en anneau,

la fig. 3 est une vue symbolique montrant le schéma équivalent d'un capteur selon l'invention,

les fig. 4 à 7 sont des vues schématiques en coupe montrant diverses étapes de fabrication de la structure de capteur de la fig. 1,

la fig. 8 est une vue schématique en coupe montrant une variante de réalisation du capteur de la fig. 1,

la fig. 9 est une vue schématique en coupe montrant un second mode de réalisation de l'invention, et,

les fig. 10 et 11 sont des vues analogues à celle de la fig. 9 mais montrent deux étapes successives de l'état de la structure du capteur de la figure 9 lors d'une opération de décollage de la lame flexible du capteur, par rapport au substrat.

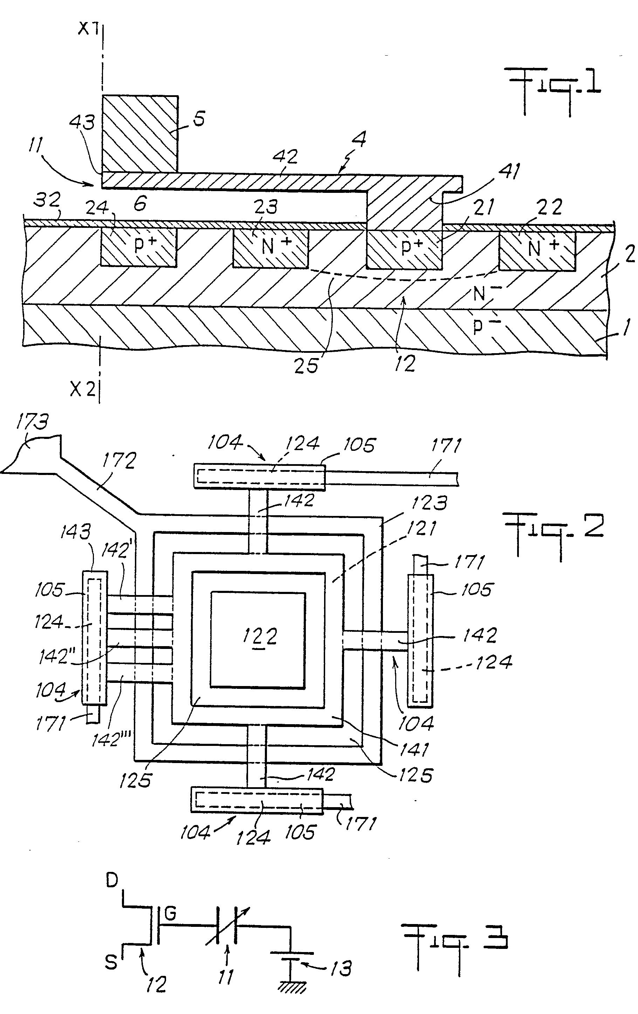

La fig. 1 représente un premier exemple de capteur de grandeurs mécaniques, pouvant constituer par exemple un accéléromètre, qui est intégré sur du silicium.

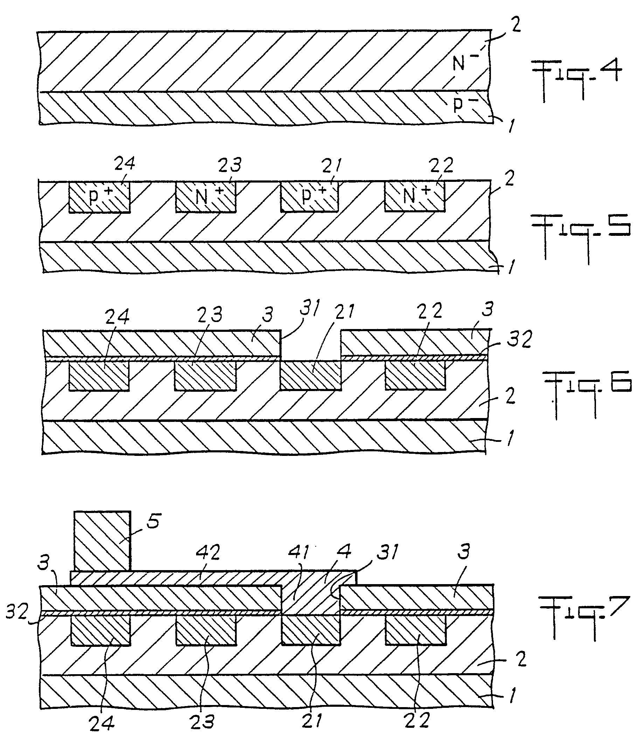

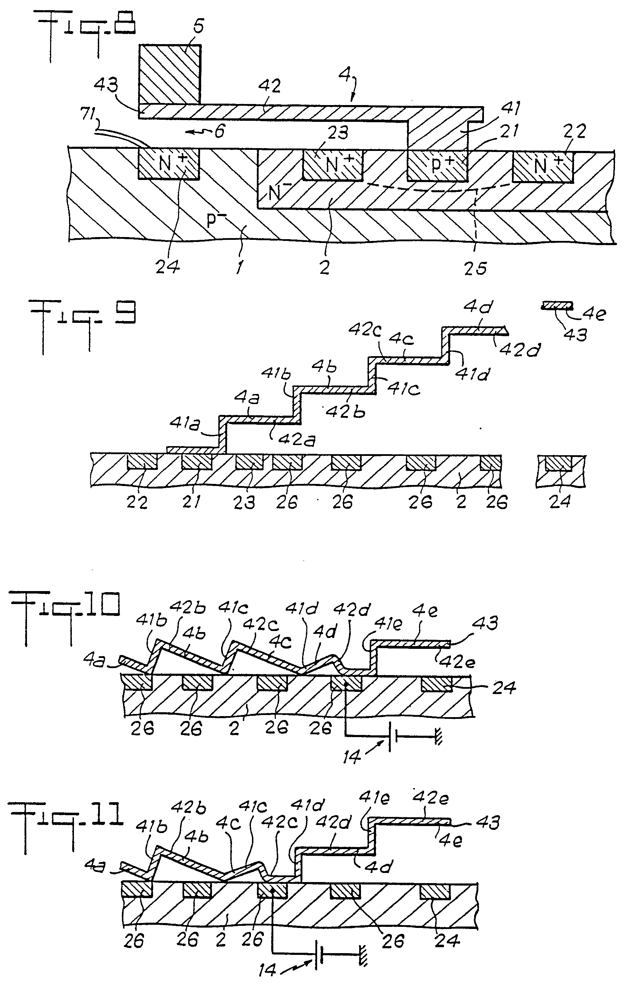

Le capteur comprend une lame 4 déformable en flexion et réalisée en silicium polycristallin de manière à être conductrice. La lame 4 comporte un extrémité 41 rattachée au substrat 1, 2 en silicium monocristallin pour former une partie d'ancrage conductrice, une partie 42 en porte-à-faux qui constitue la partie déformable de la lame et une partie d'extrémité libre 43 qui définit une première armature mobile d'un compensateur 11 (fig. 3). La partie mobile 42, 43 de la lame déformable 4 est située à une distance de la surface libre du capteur qui est de l'ordre du micron ou de quelques μm.

Dans l'exemple de la fig. 1, une couche 2 de silicium de type Ñ est formée par épitaxie sur toute la surface du substrat proprement dit 1 constitué par du silicium monocristallin de type P. Une zone 24 dans laquelle ont été diffusées des impuretés dopant le silicium, de manière à former une zone dopée $P^+$, est située dans la couche épitaxiale 2 sous l'extrémité libre 43 de la lame 4 et constitue l'armature fixe du condensateur variable 11 composé de l'armature mobile 43, de l'armature fixe 24 et de l'espace libre 6 situé entre l'armature mobile 43 et la surface libre du capteur. Dans l'exemple de la fig. 1, la surface libre du capteur est définie par une couche de passivation 32 composée, par exemple, de silice $(SiO_2)$ recouverte de nitrure de silicium $(Si_3N_4)$. Cette couche de passivation n'est, cependant, pas indispensable et peut être omise, comme dans l'exemple de réalisation de la fig. 8. Une tension de polarisation est appliquée entre le subsrat 1, depuis l'extérieur de la structure de capteur, et la zone 24 constituant l'armature fixe du condensateur 11, à partir d'une source de tension continue 13 à laquelle peut être superposée, le cas échéant, une tension de modulation (fig. 3).

Si l'on se reporte de nouveau à la fig. 1, on voit que la zone d'ancrage 21 sur laquelle est disposée la partie d'ancrage 41 de la lame 4, est constituée par une zone diffusée de type p⁺ qui constitue la grille d'un transistor à effet de champ à jonction JFET 12. Le transistor JFET 12 comprend une zone diffusée 25 de faible concentration qui fait partie de la couche épitaxiée 2, est de signe N opposé à celui de la grille (de type p⁺), et constitue un canal à chaque extrémité duquel, ainsi que pour tout transistor JFET, ont été constituées deux zones 22, 23 de drain et de source, dont le dopage N⁺ est de même signe que celui du canal et auxquelles sont rapportées de l'extérieur des polarisations convenables (non représentées sur le schéma symbolique de la fig. 3).

L'extrémité libre 43 de la lame 4 formant armature de condensateur est, de préférence, élargie par rapport à la partie 42 constituant la partie flexible de la lame, et une surcharge 5, de masse relativement importante, réalisée, par exemple, également en silicium polycristallin et pouvant présenter une hauteur, par exemple, de l'ordre de 10 μm, est disposée sur la lame 4 au voisinage de l'extrémité libre 43 afin d'augmenter la sensiblité de la lame en porte-à-faux.

Sous l'effet d'une accélération, la lame 4 se déforme et fait varier la distance de l'espace libre 6 entre l'extrémité libre 43 portant la surcharge 5 et la surface libre du capteur. Il s'ensuit, par variation de la capacité du condensateur variable 11, un transfert de charge vers la grille 21 du transistor JFET 12 qui module donc le courant drain-source entre les zones 22 et 23.

L'utilisation d'un transistor 12 de type JFET, réalisé au voisinage de la zone d'ancrage 21 de la lame flexible 4, permet de diminuer le bruit inhérent aux dispositifs électroniques comprenant des transistors MOS et de limiter la dérive du dispositif dans le temps. La réalisation de la lame 4 en un matériau conducteur tel que le silicium polycristallin s'avère également plus satisfaisante que l'utilisation de lames métalliques ou constituées à la fois d'un matériau isolant et d'une armature conductrice comme dans la plupart des capteurs connus.

On a représenté sur la fig. 2 en vue de dessus un capteur intégré du type de celui de la fig. 1 dans lequel le transistor JFET 12 est réalisé selon une configuration en anneau qui évite qu'une partie du courante, entre le drain et la source, ne soit pas influencé par la grille.

Sur la fig. 2, on voit ainsi un transistor JFET 12 qui comprend une zone centrale dopée 122, à forte concentration d'impuretés de type N⁺, pouvant constituer le drain ou la source du transistor JFET. La zone centrale 122 est entourée, de façon non contiguë, par une zone de grille 121, dopée avec des impuretés de type p⁺. Une zone périphérique dopée 123, de source ou de drain, à forte concentration d'impuretés de type N⁺, entoure elle-même de façon non contiguë la zone de grille 121. Une zone de canal 125 s'étend entre la zone centrale 122 et la zone de grille 121, sous la zone de grille 121 et entre la zone de grille 121 et la zone périphérique 123.

A titre d'exemple, la zone centrale 122 peut s'étendre sur une surface de l'ordre de 100 μm × 100 μm tandis que les couronnes 121, 123, entourant la zone centrale 122, peuvent présenter, dans le sens radial, une largeur de l'ordre de 10 μm. Lorsque la zone centrale 122 est de dimensions suffisamment importantes, un contact peut être relié directement à cette zone. Le contact 173 de la zone périphérique 123 est lui-même relié à cette dernière par un chemin conducteur 172.

Dans le mode de réalisation de la fig. 2, une lame 104 présente une partie flexible 142 en porte-à-faux qui se termine par une partie d'extrémité libre 143 élargie et surmontée d'une surcharge 105. La partie d'ancrage 141 de la lame 104 présente elle-même la forme d'un anneau superposé à la zone de grille 121 et entourant la zone centrale 122 de drain ou source du transistor JFET. Une zone conductrice 124, reliée par une piste 171 à un contact non représenté, est disposée sur la surface libre du substrat en regard de l'extrémité libre 143 de la lame 104, sous celle-ci. Bien que le capteur avec transistor JFET, du type en anneau, puisse ne comporter qu'une seule lame 104, sur la fig. 2, on a représenté quatre lames flexibles 104 s'étendant radialement vers l'extérieur depuis la couronne d'ancrage 141.

Le présence de plusieurs lames flexibles 104, disposées de manière symétrique par rapport à deux plans, perpendiculaires entre eux et perpendiculaires au plan de la fig. 2, permet, en effet, d'améliorer les performances du capteur qui, du fait des différentes symétries, est rendu plus insensible aux accélérations transversales. L'axe sensible du capteur de la fig. 2, prévu pour être perpendiculaire au plan du dessin, est ainsi d'autant mieux défini que les lames 104 sont indentiques et disposées symétriquement par rapport à des plans passant par ledit axe, car l'exploitation de l'ensemble des signaux, engendrés par les déplacements des différentes lames 103, permet de réaliser une compensation des influences excercées selon des axes différents de l'axe principal de sensibilité du capteur.

Par ailleurs, chaque lame flexible 4, 104 peut s'étendre en largeur sur une distance relativement grande, tout en étant munie d'évidements, afin d'augmenter le rapport entre la flexibilité dans le sens longitudinal et la flexibilité dans le sens transversal. On a ainsi représenté, sur la fig. 2, l'une des lames flexibles 104 (à gauche de la figure) sous la forme d'un ensemble de trois languettes parallèles 142', 142'', 142''', écartées l'une de l'autre, rattachées à la couronne d'ancrage 141 en des points distincts et réunies à leurs extrémités libres par une patie d'extrémité commune 143.

Dans la description qui précède, on a considéré le cas de lames 4, 104 en porte-à-faux. Un capteur selon l'invention peut aussi comprendre l'association symétrique de duex ou plusieurs capteurs dans lesquels les parties d'extrémité 43, 143 des lames flexibles 4, 104 sont réunies entre elles pour former une lame flexible unique ancrée à plusieurs extrémités. Avec le mode de réalisation de la fig. 1, un tel capteur à lame flexible unique pourrait ainsi présenter un axe de symétrie correspondant à l'axe X1—X2 de la fig. 1.

Dans les capteurs de grandeurs mécaniques comprenant une lame en porte-à-faux située à une très faible distance de la surface libre du substrat, c'est-à-dire définissant un espace libre 6 de très faible épaisseur, de l'ordre de 1 ou 2 µm, il existe toujours un risque que le partie en porte-à-faux 42, 142 de la lame 4, 104 vienne se coller contre le substrat du fait de l'attraction exercée entre deux zones de dopage de type différent. De plus, la lame en porte-à-faux, qui est de faible épaisseur, par exemple de l'ordre de 0,5 ou 1 micron, présente une fragilité qui rend la fabrication du capteur intégré délicate.

Meilleure Maniere de Realiser l'Invention:

On décrira en référence aux fig. 1 et 4 à 7 un exemple de procédé de fabrication qui permet de limiter les risques de rupture du capteur au cours de sa fabrication.

Dans une première étape, représentée sur la fig. 4, et qui reste classique, on dépose sur un substrat 1 de type P, par épitaxie, une couche 2 silicium de type N.

On procède ensuite à une oxydation en surface et à la photogravure de l'oxyde pur réaliser les zones $N^+$ 22, 23 de drain et de source du transistor JFET, puis à une oxydation et gravure pour réaliser la zone $P^+$ 21, constituant la grille du transistor JFET, et la zone $p^+$ 24 constituant l'armature fixe du condensateur vairable 11. Ces opérations qui, en soi, sont classiques, ne sont pas décrites de façon plus détaillée et la fig. 5 représente l'état de la plaquette de silicium à la fin des étapes indiquées ci-dessus.

Dans une étape suivante, on procède, le cas échéant, au dépôt d'une couche de passivation 32, puis à une oxydation pour former une couche 3 de silice présentant l'épaisseur souhaitée pour l'espace libre 6, et on procède à la gravure d'un puits 31 au-dessus de la zone 21 de grille, afin de permettre ensuite un ancrage de la lame 4 (fig. 6).

Les étapes représentées sur la fig. 7 consistent, essentiellement, à déposer du polysilicium dopé $p^+$ dans le puits 31 et sur la couche 3 de SiO2, puis à graver ce polysilicium pour former la lame 4 avec une partie d'ancrage 41 et une partie 42 toujours supportée par la couche 3 de SiO2 mais destinée à présenter ensuite un porte-à-faux.

On procède ensuite à la fabrication éventuelle d'une surchage 5, et à un certain nombre d'opérations non représentées sur les dessins et comprenant l'ouverture de contacts à travers la couche 3 de SiO2 et la couche de passivation 32, lorsqu'elle existe, le dépôt d'aluminium et la photogravure de l'aluminium pour réaliser des chemins conducteurs de connexion, la découpe des plaquettes, la mise en boîtier et la soudure de plots par des fils de contact en aluminium ou en or reliant les plots aux contacts macroscopiques.

Ces différentes opérations ne présentent pas d'originalité en elles-mêmes mais sont toutes réalisées alors que la lame 42 est toujours supportée par la couche 3 de SiO2. On évite ainsi que des débris viennent se coincer sous la lame 4 lors des différentes opérations de découpe ou que la résistance mécanique de la lame soit affaiblie puisque cette lame reste supportée par une couche d'oxyde de silicium jusqu'à l'étape de soudure des plots.

L'étape finale permettant d'aboutir à la structure de la fig. 1, c'est-à-dire à la réalisation d'une petite lame 4 en porte-à-faux, consiste en une attaque chimique de la couche 3, y compris sous la partie 42 de la lame 4, par un courant d'acide fluorhydrique gazeux anhydre à une température comprise entre environ 50°C et 200°C, et, de préférence, comprise entre 50°C et 100°C, dans des conditions qui empêchent la formation de gouttelettes de liquide sur la plaquette de capteur. L'attaque de la couche 3 d'oxyde peut s'effectuer par exemple à une vitesse de l'ordre de 1 µm/minute.

Compte tenu des conditions opératoires de cette dernière étape (attaque à chaud avec un débit de gaz), la couche 3 de silice peut être attaquée de manière sèche sans redépôt gelatineux et les dépôts d'aluminium ne sont eux-mêmes pratiquement pas attaqués et conservent toutes leurs propriétés conductrices.

Naturellement, l'exemple de procédé de fabrication décrit ci-dessus peut subir de nombreuses variantes et toutes les techniques utilisées de manière usuelle en microélectronique peuvent être utilisées.

Ainsi, les dopages des zones 21, 22, 23 et, le cas échéant, de la zone conductrice 24 peuvent être réalisés aussi bien par diffusion que par implantation ionique. La couche 2 de type N réalisée sur le substrat 1 de type P n'est pas nécessairement formée par épitaxie. La couche 2 de type N, entourant les zones de drain et de source 22, 23, peut former un simple caisson qui ne s'étend pas jusqu'a la zone conductrice 24 située en regard de l'extrémité libre 43 de la lame 4 (fig. 8). Dans ce cas, la zone conductrice 24, qui constitue l'armature fixe du condensateur 11 reliée à une connexion 71, réalisée par dopage à forte concentration d'impuretés du type $N^+$.

Par ailleurs, dans les exemples de réalisation décrits dans la présente demande de brevet, il est naturellement possible d'inverser les signes de toutes les zones dopées. Ainsi, dans la description, le premier type de dopage A, $A^+$, peut être le type P, $P^+$ tandis que le second type de dopage B, $B^+$ est le type N, $N^+$, mais il est possible, de la même façon, de considérer que le premier type de dopage A, $A^+$ est constitué par le type N, $N^+$ tandis que le second type de dopage B, $B^+$ est constitué par le type P, $P^+$.

On a déjà indiqué plus haut que la lame en porte-à-faux 4 d'un capteur de grandeurs mécaniques de type capacitif présentant un espace libre 6 de très faibles dimensions, pouvait accidentellement venir se coller sur la surface libre supérieure du substrat.

Un mode particulier de réalisation représenté sur les figures 9 à 11 permet de remédier à cet inconvénient et, en cas de collage accidentel de la lame en porte-à-faux 4, par exemple par suite d'un choc sur le capteur, offre la possibilité de ramener le capteur dans son état initial et donc éviter sa mise hors service, un démontage du capteur n'étant pas envisageable.

Le capteur de la fig. 9 présente une lame flexible 4 en escalier constituée par un ensemble de tronçons successifs 4a, 4b, . . . 4e en forme de marches d'escalier. La première marche d'escalier 4a comprend une première partie verticale d'ancrage 41a à laquelle est rattachée une partie horizontale 42a en porte-à-faux d'une manière analogue à la lame 4 des fig. 1 et 8. Une partie verticale 41b est disposée à la place de la surcharge 5 des fig. 1 et 8, et constitue la contre-marche de la marche 4b dont la partie horizontale 42b est située à une distance plus élevée par rapport à la surface libre du capteur que la partie horizontale 42a de la première marche 4a. La lame flexible 4 peut ainsi comprendre, par exemple, cinq marches successives 4a à 4e avec des contre-marches 41a à 41e et des parties horizontales 42a à 42e dont la dernière 42e constitue l'extrémité libre 43 de la lame formant armature mobile du condensateur 11 et est située en regard d'une zone conductrice 24 formant l'armature fixe du condensateur variable 11.

La première contre-marche 41a formant zone d'ancrage surmonte elle-même une zone dopée 21 constituant la grille du transistor JFET 12, dont les zones dopées de drain et de source 22, 23 entourent sans contact la grille 21.

Chaque marche d'escalier 4a à 4e coopère avec une zone dopée 26 à forte concentration d'impuretés formée dans le substrat 1 ou la couche épitaxiale 2 surmontant le substrat 1 et située sous la marche correspondante.

La longueur de la partie horizontale 42a à 42e de chaque marche 4a à 4e est inférieure à une longueur critique de collage tandis que la longueur totale de la lame comprise entre la partie d'ancrage 41a et la projection sur le substrat de l'extrémité libre 43 est très supérieure à cette longueur critique de collage.

On expliquera maintenant en référence aux fig. 10 et 11 la façon dont la lame en escalier 4, du type représenté sur la fig. 9, peut être décollée facilement du substrat par la simple application successive de tensions de polarisation sur les zones dopées 26 formées sous les différentes marches d'escalier 4a, . . . 4e.

Si la lame 4 a été collée accidentellement, on applique, successivement, des tensions de polarisation sur les zones 26, en commençant par la zone 26 située sous la marche d'escalier 4d qui suit immédiatement la marche 4e voisine de l'extrémité libre 43 de la lame (fig. 10). L'application d'une force sur la marche 4d par la tension de polarisation de la source 14 exercée sur la zone 26 correspondante permet d'augmenter la longueur de la partie collée de la partie 42d de la marche 4d et, par suite, de tendre à faire remonter la marche suivante 4e voisine de l'extrémité libre 43. La marche 4e peut ainsi être décollée, comme représenté sur la fig. 10, tandis que les marches 4a à 4d restent collées.

En commutant la source 14 de tension de polarisation de proche en proche sur la marche 4c (fig. 11) puis 4b, 4a, on peut faire se décoller les différentes marches 4d, 4c, 4b. La dernière marche dont la longueur est inférieure à la longueur critique de collage peut elle-même se décoller automatiquement lorsque l'on n'applique plus aucune tension de polarisation sur les zones 26.

A titre d'exemple, une lame 4 en polysilicium peut comprendre, par exemple, quatre marches présentant chacune une longueur de 40 μm environ et une épaisseur de 2 microns. La tension de polarisation appliquée successivement sur les zones dopées 26 peut être de l'ordre de 10 volts environ.

Application Industrielle:

L'objet de l'invention est particulièrement destiné à être mis en oeuvre pour la constitution d'accéléromètres ou de capteurs de pression.

**Revendications:**

1. Capteur de grandeurs mécaniques intégré sur silicium, comprenant un substrat (1) de silicium monocristallin présentant un premier type de dopage A, un condensateur variable (11) comprenant une première armature mobile (43) constituée par l'extrémité libre d'une lame conductrice (4) déformable en flexion montée de manière à présenter une partie (42) en porte-à-faux, et une second armature fixe (24) constituée par une zone conductrice réalisée au niveau de la surface libre fixe du capteur en regard de ladite première armature (43) et séparée de celle-ci par un espace libre dont l'épaisseur et de l'ordre de quelques μm et des moyens de détection d'un signal electrique significatif représentatif des variations de position de ladite lame flexible (4), caractérisé en ce que le substrat (1) est recouvert sur au moins une partie de sa surface par une couche dopée (2) présentant un second type de dopage B, en ce que ladite lame déformable conductrice (4) présente une partie d'ancrage conductrice (41) rapportée sur une zone localisée (21) de ladite couche dopée (2), en ce que le capteur comprend dans ladite couche dopée (2) une première zone (21) dopée à forte concentration d'impuretés du premier type A⁺ située dans ladite zone localisée (21) d'ancrage de la lame flexible (4) pour constituer la grille G d'un transistor à effet de champ à jonction JFET (12), des seconde et troisième zones (22, 23) dopées à forte concentration d'impuretés du second type B⁺ situées de part et d'autre de ladite première zone dopée (21) pour constituer des zones de grain D et de source S du transistor JFET (12), la couche dopée (2) définissant une zone (25) à faible concentration d'impuretés dudit second type B située sous ladite première zone dopée (21) entre lesdites seconde et troisième zones (22, 23) pour constituer le canal dudit transistor JFET (12) dont la grille G est reliée directement par la lame flexible (4) à l'armature mobile (43) du condensateur variable (11).

2. Capteur selon la revendication 1, caractérisé en ce que la lame flexible (4) est constituée en polysilicium dopée pour le rendre conducteur.

3. Capteur selon la revendication 1 ou la revendication 2, caractérisé en ce que ladite zone conductrice (24) sous-jacente est constituée par une quatrième zone dopée à forte concentration d'impuretés du second type B$^+$ réalisée directement dans le substrat (1).

4. Capteur selon la revendication 1 ou la revendication 2, caractérisé en ce que ladite zone conductrice (24) sous-jacente est constituée par une quatrième zone dopée à forte concentration d'impuretés due premier type A$^+$ réalisée dans la couche dopée (2).

5. Capteur selon l'une quelconque des revendications 1 à 4, caractérisé en ce que la lame présente à l'extrémité libre (43) de la partie flexible (42) en porte-à-faux une partie élargie sur laquelle peut être disposée une surcharge (5).

6. Capteur selon l'une quelconque des revendications 1 à 5, caractérisé en ce que la lame flexible (4) présente une largeur relativement importante et est ajourée pour augmenter le rapport entre la flexibilité dans le sens longitudinal et la flexibilité dans le sens transversal.

7. Capteur selon l'une quelconque des revendications 1 à 6, caractérisé en ce que la surface libre du capteur en silicium monocristallin est recouverte d'une couche de passivation (32).

8. Capteur selon l'une quelconque des revendications 1 à 7, caractérisé en ce qu'il comprend un transistor JFET (12) réalisé en anneau avec une seconde zone (122) de drain ou de source qui constitue une zone centrale, une première zone (121) de grille qui entoure de façon non contiguë la zone centrale (122) de drain ou de source, une troisième zone (123) de source ou de drain qui entoure elle-même de façon non contiguë la première zone (121) de grille, une zone conductrice périphérique (124) qui est disposée de façon non contiguë à l'exterieur de la troisième zone (123) de source ou de drain, une zone (125) de canal située dans les intervalles entre les seconde et première zones (122, 121), entre les première et troisième zones (121, 123) et sous celles-ci, et en ce que la lame flexible (104) présente une partie en porte-à-faux qui s'étend radialement vers l'extérieur, de la première zone (121) vers la zone conductrice (124).

9. Capteur selon la revendication 8, caractérisé en ce qu'il comprend plusieurs lames flexibles (104) s'étendant radialement vers l'exterieur entre une zone d'ancrage constituée par une couronne (141) superposée à la première zone (121) et des zones conductrices (124) en nombre égal au nombre de lames flexibles (104) et non contiguës entre elles, au-dessus desquelles s'étendent respectivement les parties terminales d'extrémité libre (143) des lames flexibles (4).

10. Capteur selon la revendication 9, caractérisé en ce que les lames flexible (104) sont disposées de façon symétrique par rapport à deux plans perpendiculaires entre eux.

11. Capteur selon l'une quelconque des revendications 1 à 9, caractérisé en ce que la lame flexible (4) présente une partie en porte-à-faux (42) constituée par un ensemble de marches d'escalier (4a, 4b, 4c, 4d, 4e) présentant chacune une longueur inférieure à une longueur critique de collage, en ce que chaque marche d'escalier coopère avec une zone dopée (26) à forte concentration d'impuretés polarisable individuellement située sous ladite marche, et en ce que des moyens sont prévus pour appliquer successivement de proche en proche sur chaque zone dopée (26) polarisable individuellement, à partir de l'extrémité libre (43) de la lame flexible (4), une polarisation pour permettre le décollage des marches successives en cas de collage accidentel de la partie libre de la lame flexible (4) sur le substrat (2).

12. Capteur de grandeurs mécaniques intégré sur silicium, caractérisé en ce qu'il est constitué par l'association symétrique de deux capteurs selon l'une quelconque des revendications 1 à 9, dans lesquels les parties d'extrémité libre (43) des lames flexibles (4) sont réunies entre elles pour former une lame flexible unique ancrée à ses deux extrémités.

13. Procédé de fabrication d'un capteur de grandeurs mécaniques intégré selon l'une quelconque des revendications 1 à 11, caractérisé en ce que l'on réalise dans un premier temps la couche dopée (2), les première, seconde et troisième zones dopées (21, 22, 23) à forte concentration d'impuretés et la zone conductrice (24), en ce que l'on forme ensuite une couche de silice qui suit la réalisation éventuelle d'une couche de passivation, en ce que l'on dégage par photogravure la silice dans la zone d'ancrage (31) de la lame flexible (4), en ce que l'on dipose une matière conductrice (41, 42, 43) dans la zone d'ancrage et sur une partie de la couche de silice pour constituer la lame flexible (4), en ce que l'on réalise le cas échéant une surcharge (5) à l'extrémité libre de la lame flexible (4), en ce que l'on procède à l'ouverture de contacts à travers la couche de silice et éventuellement de passivation, puis au dépôt d'aluminium et à la photogravure de l'aluminium pour réaliser des chemins conducteurs de connexion, en ce que l'on procède à la découpe de plaquettes, à la mise en boîtier et à la soudure de plots et en ce que dans une étape finale on enlève la silice y compris sous la matière conductrice de la partie (42) en porte-à-faux de la lame flexible (4), par de l'acide fluorhydrique gazeux anhydre à une température comprise entre environ 50°C et 200°C et, de préférence, comprise entre 50°C et 100°C de manière à empêcher la formation de liquide sur la plaquette.

**Patentansprüche**

1. Auf Silizium integrierter Aufnehmer mechanischer Größen mit einem Substrat (1) aus einkristallinem Silizium, das einen ersten Dotierungstyp (A) aufweist, einem einstellbaren Kondensator (11), der eine erste, bewegliche Belegung (43), die aus dem freien Ende eines leitenden, biegeverformbaren Plättchens (4) bestcht, das unter Aufweisen eines freitragenden Teils (42) montiert ist, und eine zweite, feste Belegung (24) aufweist, die aus einer leitenden Zone besteht, die auf Höhe der freien festen Oberfläche des Aufnehmers gegenüber der ersten Belegung (43) vorgesehen und von dieser durch einen freien Zwischenraum getrennt ist, dessen Dicke in der Größenordnung einiger μm ist, und mit Mitteln zum Errassen eines kennzeichnenden, Lageänderungen des flexiblen Plättchens (4) wiedergebenden elektrischen Signals, dadurch gekennzeichnet, daß das Substrat (1) winigstens auf einem Teil seiner Oberfläche von einer dotierten Schicht (2) bedeckt ist, die einen zweiten Dotierungstyp (B) aufweist, daß das verformbare leitende Plättchen (4) einen leitenden Verankerungsteil (41) aufweist, der auf einer begrenzten Zone (21) der dotierten Schicht (2) aufgesetzt ist, daß der Aufnehmer in der dotierten Schicht (2) eine erste, mit starker Konzentration von Verunreinigungen des ersten Typs (A⁺) dotierte Zone (21), die sich in der begrenzten Verankerungszone (21) des flexiblen Plättchens (4) zur Bildung des Gates (G) eines Feldeffekttransistors mit Übergang (JFET) (12) befindet, sowie zweite und dritte, mit starker Konzentration von Verunreinigungen (B⁺) dotierte Zonen (22, 23) aufweist, die sich beiderseits der ersten dotierten Zone (21) zur Bildung der Senke (D)- und Quelle (S)-Zone des JFET-Transistors (12) befinden, wobei die dotierte Schicht (2) eine Zone (25) schwacher Konzentration von Verunreinigungen des zweiten Typs (B) abgrenzt, die sich unter der ersten dotierten Zone (21) zwischen den zweiten und dritten Zonen (22, 23) zur Bildung des Kanals des JFET-Transistors befindet, dessen Gate (G) durch das flexible Plättchen (4) direkt mit der beweglichen Belegung (43) des einstellbaren Kondensators (11) verbunden ist.

2. Aufnehmer nach dem Anspruch 1, dadurch gekennzeichnet, daß das flexible Plättchen (4) aus, um es leitend zu machen, dotiertem Polysilizium besteht.

3. Aufnehmer nach dem Anspruch 1 oder dem Anspruch 2, dadurch gekennzeichnet, daß die darunterliegende leitende Zone (24) aus einer vierten, mit starker Konzentration von Verunreinigungen des zweiten Typs (B⁺) dotierten, direkt im Substrat (1) vorgesehenen Zone besteht.

4. Aufnehmer nach dem Anspruch 1 oder dem Anspruch 2, dadurch gekennzeichnet, daß die darunterliegende leitende Zone (24) aus einer vierten, mit starker Konzentration von Verunreinigungen des ersten Typs (A⁺) dotierten, in der dotierten Schicht (2) vorgesehenen Zone besteht.

5. Aufnehmer nach irgendeinem der Ansprüche 1 bis 4, dadruch gekennzeichnet, daß das Plättchen am freien Ende (43) des flexiblen freitragenden Teils (42) einen erweiterten Teil aufweist, auf dem eine Belastung (5) angeordnet werden kann.

6. Aufnehmer nach irgendeinem der Ansprüche 1 bis 5, dadurch gekennzeichnet, daß das flexible Plättchen (4) eine relativ erhebliche Breite aufweist und gelocht ist, um das Verhältnis zwischen der Flexibilität in der Längsrichtung und der Flexibilität in der Querrichtung zu erhöhen.

7. Aufnehmer nach irgendeinem der Ansprüche 1 bis 6, dadruch gekennzeichnet, daß die freie Oberfläche des Aufnehmers aus einkristallinem Silizium mit einer Passivierungsschicht (32) bedeckt ist.

8. Aufnehmer nach irgendeinem der Ansprüche 1 bis 7, dadruch gekennzeichnet, daß er einen in Ringform ausgebildeten JFET-Transistor (12) mit einer zweiten Senke- oder Quellezone (122), die eine zentrale Zone darstellt, einer ersten Gatezone (121), die die zentrale Senke- oder Quellezone (122) nichtberührend umgibt, einer dritten Quelle- oder Senkezone (123), die ihrerseits die erste Gatezone (121) nichtberührend umgibt, einer leitenden Umfangszone (124), die nichtberührend außerhalb, der dritten Quelle- oder Senkezone (123) angeordnet ist, und einer Kanalzone (125), die sich in den Zwischenräumen zwischen der zweiten und der ersten Zone (122, 121) zwischen der ersten und der dritten Zone (121), 123) und unter diesen befindet, aufweist und daß das flexible Plättchen (104) einen freitragenden Teil aufweist, der sich radial nach außen von der ersten Zone (121) zur leitenden Zone (124) erstreckt.

9. Aufnehmer nach dem Anspruch 8, dadurch gekennzeichnet, daß er mehrere flexible Plättchen (104) aufweist, die sich radial nach außen zwischen einer Verankerungszone, die durch eine auf die erste Zone (121) aufgebrachte Krone (141) gebildet ist, und leitenden Zonen (124) in einer der Anzahl von flexiblen Plättchen (104) gleichen Anzahl ohne gegenseitige Berührung erstrecken, über denen sich die jeweiligen Endteile des freien Endes (143) der flexiblen Plättchen (104) erstrekken.

10. Aufnehmer nach dem Anspurch 9, dadurch gekennzeichnet, daß die flexiblen Plättchen (104) in symmetrischer Weise bezüglich zweier zueinander senkrecheter Ebenen (A₁—A₂ und A₃—A₄) angeordnet sind.

11. Aufnehmer nach irgendeinem der Ansprüche 1 bis 9, dadurch gekennzeichnet, daß das flexible Plättchen (4) einen freitragenden Teil (42) aufweist, der aus einer Gruppe von Treppenstufen (4a, 4b, 4c, 4d, 4e) gebildet ist, deren jede einen Länge unter einer kritischen Kleblänge aufweist, daß jede Treppenstufe mit einer mit starker Verunreinigungskonzentration dotierten Zone zusammenwirkt, die einzeln polarisierbar und unter der Stufe angeordnet ist, und daß Mittel vorgesehen sind, um nacheinander schrittweise an jede einzeln polarisierbare dotierte Zone (26), ausgehend vom freien Ende (43) des flexiblen Plättchens (4), eine Polarisation anzulegen, im die Ablösung der aufeinanderfolgenden Stufen im Fall zufälligen Klebens des freien Teils des flexiblen Plättchens (4) auf dem Substrat (2) zu ermöglichen.

12. Auf Silizium integrierter Aufnehmer mechanischer Grössen, dadurch gekennzeichnet, daß er aus der symmetrischen Vereinigung zweier Aufnehmer nach irgendeinem der Ansprüche 1 is 9 besteht, bei denen die freien Endteile (43) der flexiblen Plättchen (4) miteinander zur Bildung eines einzigen, an seinen beiden Enden verankerten Plättchens verbunden sind.

13. Verfahren zur Herstellung eines integrierten Aufnehmers mechanischer Größen nach ingendeinem der Ansprüche 1 bis 11, dadurch gekennzeichnet, daß man zu einer ersten Zeit die dotierte Schicht (2), die erste, zweite und dritte dotierte Zone (21, 22, 23) mit starker Verunreinigungskonzentration und die leitende Zone (24) herstellt, daß man anschließend eine Siliziumdioxidschicht bildet, auf die die eventuelle Herstellung einer Passivierungsschicht, folgt, daß man durch Photogravur das Siliziumdioxid in der Verankerungszone (31) des flexiblen Plättichens (4) entfernt, daß man ein leitendes Material (41, 42, 43) in der Verankerungszone und auf einem Teil der Siliziumdioxidschicht anbringt, um das flexible Plättchen (4) zu bilden, daß man ggf. eine Belastung (5) am freien Ende des flexiblen Plättchens (4) vorsieht, daß man die Öffnung von Kontakten durch die Siliziumdioxid- und ggf. Passivierungsschicht, dann die Abscheidung von Aluminium und die Photogravur des Aluminiums zur Herstellung der Verbindungsleiterbahnen vernimmt, daß man das Abschneiden von Plättchen, das Eirbrigen in ein Gehäuse und das Schwießen von Kontakter durchfürt und daß man in einem letzten Schritt das Siliziumdioxid unter dem leitenden Material des freitragenden Teils (42) des flexiblen Plättchens (4) durch gasförmige wasserfreie Flußsäure bei einer Temperatur im Bereich von etwa 50°C bis 200°C und vorzugsweise im Bereich von 50°C bis 100°C derart entfernt, un die Bildung von Flüssigkeit auf dem Plättchen zu verhindern.

**Claims**

1. Silicon-integrated sensor for mechanical quantities, comprising a substrate (1) of monocrystalline silicon having a first type of doping (A), a variable capacitor (11) comprising a first movable armature (43) constituted by the free end of a conducting plate (4) which is deformable under bending stresses and is mounted so as to present a cantilvered part (42), and a second fixed armature (24) constituted by a conducting zone provided at the level of the fixed free surface of the sensor in facing relationship to said first armature (43) and separated therefrom by a free space whose thickness is in the region of a few micrometers and means of detecting a significant electrical signal representing the variations in the position of the flexible plate (4), characterized in that the substrate (1) is coated over at least part of its surface with a doped layer (2) having a second type of doping (B), in that said conducting deformable plate (4) has a conducting anchoring part (41) produced on a localized zone (21) of said doped layer (2), in that the sensor comprises in said doped layer (2) a first zone (21) doped with a high concentration of impurities of first type $(A^+)$ situated in said localized anchoring zone (21) of the flexible plate (4) in order to constitute the gate electrode (G) of a junction gate field effect transistor JFET (12), second and third zones (22, 23) doped with a high concentration of impurities of the second type $(B^+)$ situated on either side of said first doped zone (21) in order to constitute drain (D) and source (S) zones of the JFET (12), the doped zone (2) defining a zone (25) with a low concentration of impurities of said second type (B) situated under the first doped zone (21) between said second and third zones (22, 23) in order to constitute the channel of said JFET (12) whose electrode gate (G) is directly concected via the flexible plate (4) to the movable armature (43) of the variable capacitor (11).

2. Sensor according to claim 1, characterized in that the flexible plate (4) is made from polysilicon which has been made conducting by doping.

3. Sensor according to claim 1 or claim 21, characterized in that said subjacent conducting zone (24) is constituted by a fourth zone doped with a high concentration of impurities of the second type $(B^+)$ produced directly on the substrate (1).

4. Sensor according to claim 1 or claim 2, characterized in that said subjacent conducting zone (24) is constituted by a fourth zone doped with a high concentration of impurities of the second type $(A^+)$ produced in the doped layer (2).

5. Sensor according to any one of claims 1 to 4, characterized in that the plate is provided at the free end (43) of the flexible cantilevered part (42) a broadened part on which an overload (5) can be placed.

6. Sensor according to any one of claims 1 to 5, characterized in that the flexible plate (4) is of relatively great width and is perforated to increase the ratio of the flexibility in longitudinal direction to the flexibility in transverse direction.

7. Sensor according to any one of claims 1 to 6, characterized in that the free surface of the sensor in monocrystalline silicon is coated with a passivating layer (32).

8. Sensor according to any one of claims 1 to 7, characterized in that it comprises a JFET (12) produced in ring form with a second drain or source zone (122) which constitutes a central zone, a first gate zone (121) surrounding in non-contiguous manner the central drain or source zone (122), a third drain or source zone (123) which itself surrounds in non-contiguous manner the first gate zone (121), a peripheral conducting zone (124) situated in non-contiguous manner outside the third drain or source zone (123), a channel zone (125) situated in the intervals between the second and first zones (122, 121), between the first and third zones (121, 123) and under the latter, and in that the flexible plate (104) has a cantilevered part which extends radially outwardly, from the first zone (121) toward the conducting zone (124).

9. Sensor according to claim 8, characterized in that it comprises a plurality of flexible plates (104) extending radially outwardly between an anchoring zone constituted by a surround (141) superposed to the first zone (121) and conducting zones (124) equal in number to that of flexible plates (104) and in non-contiguous relationship one with respect to the other, above which zones respectively extend the free end portions (143) of the flexible plates (4).

10. Sensor according to claim 9, characterized in that the flexible plates (104) are arranged symmetrically with respect to two planes perpendicular one to the other ($A_1$—$A_2$ and $A_3$—$A_4$).

11. Sensor according to any one of claims 1 to 9, characterized in that the flexible plate (4) is provided with a cantilevered part (42) constituted by a set of steps (4a, 4b, 4c, 4d, 4e) each step having a length shorter than a critical bonding length, in that each step cooperates with an individually polarisable zone (26) doped with a high concentration of impurities and situated under said step, and in that means are provided for successively applying, in degrees on each individually polarisable doped zone (26), from the free end (43) of the flexible plate (4), a polarization permitting the separation of the successive steps in case of accidental bonding of the free part of the flexible plate (4) on the substrate (2).

12. Silicon-integrated sensor of mechanical quantities, characterized in that it is constituted by the symmetrical association of two sensors according to any one of claims 1 to 9, wherein the free end portions (43) of the flexible plates (4) are interconnected in order to form a single flexible plate anchored at its two ends.

13. Process for the production of an integrated sensor of mechanical quantities according to any of claims 1 to 11, characterized in that it consists first in producing the doped layer (2), the first, second and third zones (21, 22, 23) doped with high concentrations of impurities and the conducting zone (24), then in forming a layer of silica after optionally forming a passivating layer, in releasing by etching the silica in the anchoring zone (31) of the flexible plate (4), in placing a conducting material (41, 42, 43) in the anchoring zone and over part of the layer of silica to constitute the flexible plate (4), in producing if necessary an overload (5) on the free end of the flexible plate (4), in proceeding with opening contacts through the layer of silica and optionally through the passivating layer, then in depositing aluminium and etching the aluminium in order to produce conducting connection paths, in cutting out small boards, packaging them and soldering contacts, and, in a final step, removing the silica, including that under the conducting material of the cantilevered part (42) of the flexible plate (4), using anhydrous gaseous hydrofluoric acid at a temperature ranging between about 50°C and 200°C, and preferably ranging between 50°C and 100°C so as to prevent the formation of liquid on the board.

X1

*Fig.1*

43 5

11

32  24  6  23  42  4  41  21  22

p+  N+  p+  N+

N—  2

25  12  p—  1

X2

173

172

104  124  105  171

*Fig. 2*

142  123

121

143  142'

105  171

124  142''  122  105

142  124

104  104

171  142

125  141

142'''  125

125  142

104  124  105  171

D

G

*Fig. 3*

S

12  11  13

Fig.4

Fig.5

Fig.6

Fig.7

Fig.8

Fig.9

Fig.10

Fig.11